# EUROPEAN PATENT APPLICATION

(11) **EP 4 841 321 A1**
(43) Date of publication of application: **18.11.2026**
(21) Application number: 24919738.5
(22) Date of filing: 13.09.2024
(51) Int. Cl.: G02B 6/42

(54) **OPTICAL COMMUNICATION ASSEMBLY, SOCKET, AND OPTICAL COMMUNICATION DEVICE**

(30) Priority: 23.01.2024 CN 202410094712
(71) Applicant: Huawei Technologies Co., Ltd., Shenzhen, Guangdong 518129 (CN)
(72) Inventor: WU, Chaojie, Shenzhen, Guangdong 518129 (CN); WANG, Guoliang, Shenzhen, Guangdong 518129 (CN); GUO, Yanliang, Shenzhen, Guangdong 518129 (CN); MENG, Qinglei, Shenzhen, Guangdong 518129 (CN); XU, Zihao, Shenzhen, Guangdong 518129 (CN); YANG, Ying, Shenzhen, Guangdong 518129 (CN); SU, Changzheng, Shenzhen, Guangdong 518129 (CN)
(74) Representative: Huawei European IPR
(86) International application number: PCT/CN2024/118793
(87) International publication number: WO 2025/156658

(57) **Abstract**

This application relates to the field of optical communication technologies, and discloses an optical communication component, including an optoelectronic device and a socket. The optoelectronic device includes a printed circuit board, a conductive contact component is disposed at a first end of the printed circuit board, and the conductive contact component includes a signal transmission conductive contact and a signal receiving conductive contact. A first isolation strip extending along a length direction of the printed circuit board is further disposed on the printed circuit board, and the signal transmission conductive contact and the signal receiving conductive contact are located on two sides of the first isolation strip along a width direction of the printed circuit board. The socket is provided with a slot, and an isolation rib is disposed in the slot. When the conductive contact component is inserted into the slot, the isolation rib can engage with the first isolation strip, to form a first isolation portion that isolates the signal transmission conductive contact from the signal receiving conductive contact. This application can mitigate crosstalk between a signal receiving channel and a signal transmission channel in the optoelectronic device, thereby improving performance of the optoelectronic device. This application further discloses a socket and an optical communication device.

## Description

This application claims priority to Chinese Patent Application No. 202410094712.8, filed with the China National Intellectual Property Administration on January 23, 2024 and entitled "OPTICAL COMMUNICATION COMPONENT, SOCKET, AND OPTICAL COMMUNICATION DEVICE", which is incorporated herein by reference in its entirety.

### TECHNICAL FIELD

This application relates to the field of optical communication technologies, and in particular, to an optical communication component, a socket, and an optical communication device.

### BACKGROUND

In optical communication, an optoelectronic device (also referred to as an optical module) is a tool for implementing mutual conversion between an optical signal and an electrical signal, and is one of key components in an optical communication device. The optoelectronic device can be inserted into a socket of a communication device, to implement an electrical connection between the optoelectronic device and the communication device. A signal receiving channel and a signal transmission channel are provided in the optoelectronic device. The signal receiving channel can convert an external optical signal into an electrical signal, and input the electrical signal obtained through conversion into the communication device through the socket. The signal transmission channel can convert an electrical signal sent by the socket into an optical signal, and output the optical signal obtained through conversion to the outside.

In the conventional technology, isolation between a signal receiving channel and a signal transmission channel is not effectively controlled, which causes signal crosstalk between the signal receiving channel and the signal transmission channel, severely affecting overall performance of an optoelectronic device.

### SUMMARY

This application provides an optical communication component, a socket, and an optical communication device. This application can mitigate crosstalk between a signal receiving channel and a signal transmission channel in an optoelectronic device, thereby improving performance of the optoelectronic device.

According to a first aspect, this application provides an optical communication component, including an optoelectronic device and a socket. One end of the optoelectronic device can input/output an optical signal, and correspondingly, the other end of the optoelectronic device outputs/inputs an electrical signal corresponding to the optical signal.

The optoelectronic device includes a printed circuit board, and two ends of the printed circuit board along a length direction of the printed circuit board are a first end and a second end. A conductive contact component is disposed at the first end of the printed circuit board, the conductive contact component is configured to electrically connect to a terminal in a socket that is used as an insertion destination of the optoelectronic device, and the conductive contact component includes a signal transmission conductive contact and a signal receiving conductive contact. A first isolation strip extending along the length direction of the printed circuit board is further disposed on the printed circuit board, and the signal transmission conductive contact and the signal receiving conductive contact are located on two sides of the first isolation strip along a width direction of the printed circuit board.

The socket is provided with a slot, the slot can allow insertion of the conductive contact component, and an isolation rib is disposed in the slot. When the conductive contact component is inserted into the slot, the isolation rib can engage with the first isolation strip, to form a first isolation portion that isolates the signal transmission conductive contact from the signal receiving conductive contact.

In this application, the first isolation strip is disposed on the printed circuit board, and the isolation rib is disposed in the socket, so that when the conductive contact component is inserted into the socket, the first isolation strip is in lap joint with the isolation rib in the socket to form the first isolation portion. The first isolation portion can separate the signal transmission conductive contact and the signal receiving conductive contact in different isolation cavities, to implement physical isolation between the signal transmission conductive contact and the signal receiving conductive contact, and mitigate crosstalk between a transmitted signal and a received signal, thereby improving performance of the optoelectronic device.

A specific mechanism of the first isolation strip is not limited in this application. Any structure that can engage with the isolation rib in the socket to isolate the signal transmission conductive contact from the signal receiving conductive contact falls within the protection scope of this application.

In some implementations of this application, the first isolation strip is a dividing groove, a first isolation rib is disposed in the socket, and a width of the dividing groove matches the first isolation rib. In addition, when the conductive contact component is inserted into the socket, the first isolation rib is inserted into the dividing groove to form the first isolation portion, to separate the signal transmission conductive contact and the signal receiving conductive contact in different isolation space. A conductive layer grounded is disposed on a side wall of the dividing groove, the first isolation rib is made of a conductive material and is grounded, and when the first isolation rib is inserted into the dividing groove, the first isolation rib is in contact with the conductive layer.

In some implementations of this application, the first isolation strip is located on the printed circuit board, is made of a conductive material, and is grounded. In addition, a pair of second isolation ribs corresponding to a position of the first isolation strip is disposed in the socket, and the pair of second isolation ribs are made of a conductive material and are grounded. A first opening corresponding to a thickness of the first isolation strip is provided between the pair of second isolation ribs. When the conductive contact component is inserted into the socket, the first isolation strip is inserted into first opening, and the pair of second isolation ribs are respectively in lap joint with first isolation strip from two sides of a plane on which printed circuit board is located, to form first isolation portion. The first isolation portion can separate the signal transmission conductive contact and signal receiving conductive contact in different isolation space.

In this application, both the first isolation strip and the isolation rib in the socket are grounded, so that signal isolation effect between the signal transmission conductive contact and the signal receiving conductive contact can be enhanced.

In some implementations of this application, the optoelectronic device further includes a mechanical part and an optical device. A cavity is provided in the mechanical part, the printed circuit board is disposed in the cavity, and the optical device is disposed at the second end of the printed circuit board.

In some implementations of this application, a second isolation strip extending along the width direction of the printed circuit board is disposed on the printed circuit board. The conductive contact component and the optical device are located on two sides of the second isolation strip along the length direction of the printed circuit board, and the second isolation strip is configured to engage with the isolation rib in the mechanical part, to form a second isolation portion of the conductive contact component.

In this application, the second isolation strip is disposed on the printed circuit board, so that the second isolation strip is in lap joint with the isolation rib in the mechanical part to form the second isolation portion. The second isolation portion can separate an area in which the conductive contact component is located from another area, so that the conductive contact component and another element (for example, the optical device) on the printed circuit board are separated in different isolation cavities, to implement physical isolation between the conductive contact component and the another element, thereby mitigating crosstalk between the conductive contact component and the another element, and improving performance of the optoelectronic device.

In some implementations of this application, the second isolation strip is located on the printed circuit board, is made of a conductive material and is grounded. In addition, a pair of third isolation ribs corresponding to a position of the second isolation strip are disposed in the cavity of the mechanical part. The pair of third isolation ribs are made of a conductive material and are grounded, and a second opening corresponding to a thickness of the second isolation strip is provided between the pair of third isolation ribs. The printed circuit board is inserted into the second opening, and the pair of third isolation ribs are respectively in lap joint with the second isolation strip from two sides of a plane on which the printed circuit board is located, to form the second isolation portion. The second isolation portion can separate the conductive contact component and another element on the printed circuit board in different isolation space.

In this application, both the second isolation strip and the isolation ribs in the mechanical part are grounded, so that signal isolation effect between the conductive contact component and the optical device can be enhanced.

In some implementations of this application, a conductive adhesive is provided between the pair of third isolation ribs and the two sides of the plane on which the printed circuit board is located. In this application, the conductive adhesive is provided, to enhance sealing, thereby ensuring tight isolation.

In some implementations of this application, the optoelectronic device provided in this application further includes a flexible printed circuit, a signal transmission line, and a signal receiving line. The flexible printed circuit is disposed between the optical device and the printed circuit board, and the flexible printed circuit is configured to connect the optical device and the printed circuit board. The signal transmission line extends along the length direction of the printed circuit board. One end of the signal transmission line is electrically connected to the signal transmission conductive contact, and the other end of the signal transmission line is electrically connected to the optical device sequentially through the printed circuit board and the flexible printed circuit. The signal transmission line is configured to transmit a signal sent by the signal transmission conductive contact to the optical device. The signal receiving line extends along the length direction of the printed circuit board. One end of the signal receiving line is electrically connected to the signal receiving conductive contact, and the other end of the signal receiving line is electrically connected to the optical device sequentially through the printed circuit board and the flexible printed circuit. The signal receiving line is configured to transmit a signal sent by the optical device to the signal receiving conductive contact.

When the socket sends a signal to the outside, an electrical signal sent by the socket is transmitted to the optical device sequentially through the signal transmission conductive contact and the signal transmission line, and then the optical device converts the electrical signal sent by the socket into an optical signal, and transmits the optical signal to the outside. When an optical signal is transmitted from the outside, the optical device converts the optical signal into an electrical signal, and then the electrical signal is transmitted to the socket sequentially through the signal receiving line and the signal receiving conductive contact, so that the socket receives the signal.

In some implementations of this application, a second conductive area is provided on the flexible printed circuit, the second conductive area is grounded, a first protrusion corresponding to a position of the second conductive area is disposed in the cavity of the mechanical part, the first protrusion is made of a conductive material and is grounded, and the first protrusion is in contact with the second conductive area.

Through exploration, the inventor finds that impedance discontinuity occurs at a joint between the optical device and the flexible printed circuit, and an electromagnetic wave is likely to be radiated to the outside. Moreover, due to limited internal space of the optoelectronic device, the joint between the optical device and the flexible printed circuit is difficult to be completely shielded, which causes a radiation signal to couple in. In this application, the second conductive area grounded is provided on the flexible printed circuit, and the second conductive area is in lap joint with the grounded first protrusion, so that an anti-radiation capability of the optical device and the flexible printed circuit can be enhanced, radiation to the outside is reduced, and isolation is improved.

In some implementations of this application, an extension plate is disposed on the flexible printed circuit, and the second conductive area is provided on the extension plate. A second protrusion disposed opposite to the first protrusion is disposed in the cavity of the mechanical part, a third opening is provided between the first protrusion and the second protrusion, and the extension plate is disposed in the third opening. The first protrusion and the second protrusion are in contact with the extension plate on two sides of a plane on which the extension plate is located, to clamp the extension plate in the third opening, so that the second conductive area can be in close contact with the first protrusion, thereby enhancing reliability of an apparatus.

In some implementations of this application, both the signal transmission line and the signal receiving line are routed in an inner layer of the flexible printed circuit. This design can enhance isolation between the signal transmission line and the signal receiving line, reduce interference between the signal transmission line and the signal receiving line, and can also prevent the signal transmission line and the signal receiving line from interfering with another channel or being interfered by another channel.

In some implementations of this application, the signal transmission line and the signal receiving line are routed on a surface layer of the flexible printed circuit, one ground line is disposed on each of two sides of the signal transmission line and/or the signal receiving line along the width direction of the printed circuit board, and the ground line extends along the length direction of the printed circuit board. Because a radiation signal generated by the signal transmission line is higher than that of the signal receiving line, the signal transmission line is likely to interfere with the signal receiving line. In this application, electromagnetic radiation of the signal transmission line to the signal receiving line can be restricted by disposing one ground line on each of two sides of the signal transmission line. An anti-radiation capability of the signal receiving line may be enhanced by disposing one ground line on each of two sides of the signal receiving line.

In some implementations of this application, the printed circuit board includes a plurality of inner layers. When the signal transmission line and the signal receiving line are routed in the same printed circuit board, the signal transmission line and the signal receiving line are routed in different inner layers of the same printed circuit board. When there are two printed circuit boards, the signal transmission line and the signal receiving line are respectively routed in inner layers of the two printed circuit boards. The foregoing design may enhance isolation between the signal transmission line and the signal receiving line, thereby reducing interference between the signal transmission line and the signal receiving line.

According to a second aspect, this application provides a socket, where the socket is provided with a slot, an isolation rib is disposed in the slot, and the slot can allow insertion of the optoelectronic device in the optical communication component according to the first aspect. When the optoelectronic device is inserted into the slot, the isolation rib can engage with the first isolation strip on the optoelectronic device, to form the first isolation portion that isolates the signal transmission conductive contact from the signal receiving conductive contact.

According to a third aspect, this application provides an optical communication device, including the optical communication component according to the first aspect.

### BRIEF DESCRIPTION OF DRAWINGS

FIG. 1 is a diagram of a structure of a wireless small cell system;
FIG. 2 is a block diagram of a structure of a wireless small cell system;
FIG. 3 is a diagram of an optical communication component in the conventional technology;
FIG. 4 is an exploded view of FIG. 3;
FIG. 5 is a block diagram of a structure of a digital optical module SFP+;
FIG. 6 is a block diagram of a structure of a single-channel optoelectronic device;
FIG. 7 is a block diagram of a structure of a multi-channel optoelectronic device;
FIG. 8 is a diagram of a structure of a single-channel optoelectronic device provided with a barrier member;
FIG. 9 is a diagram of a structure of a multi-channel optoelectronic device provided with a barrier member;
FIG. 10 is a diagram of a structure of a multi-channel optoelectronic device provided with a wave-absorbing material;
FIG. 11 is an exploded view 1 of an optical communication component in an unassembled state according to some embodiments of this application;
FIG. 12 is an exploded view 1 of an optical communication component in an inserted state according to some embodiments of this application;
FIG. 13 is a diagram 1 of a printed circuit board according to some embodiments of this application;
FIG. 14 is an exploded view 2 of an optical communication component in an unassembled state according to some other embodiments of this application;
FIG. 15 is a diagram of a socket according to some other embodiments of this application;
FIG. 16 is an exploded view 2 of an optical communication component in an inserted state according to some other embodiments of this application;
FIG. 17 is a diagram 2 of a printed circuit board according to some other embodiments of this application;
FIG. 18 is a side view of a printed circuit board and a socket in FIG. 16;
FIG. 19 is a sectional view of FIG. 18 in a direction A-A;
FIG. 20 is an exploded view 3 of an optical communication component in an unassembled state according to some other embodiments of this application;
FIG. 21 is a diagram 3 of a printed circuit board according to some other embodiments of this application;
FIG. 22 is a cross-sectional diagram 1 of an optoelectronic device according to some other embodiments of this application;
FIG. 23 is a cross-sectional diagram 2 of an optoelectronic device according to some other embodiments of this application;
FIG. 24 is a partially enlarged diagram of a part B in FIG. 23;
FIG. 25 is a diagram of a part of a structure of an optoelectronic device according to some other embodiments of this application;
FIG. 26 is a diagram 4 of a printed circuit board according to some other embodiments of this application;
FIG. 27 is a diagram 1 of a flexible printed circuit according to some embodiments of this application;
FIG. 28 is a cross-sectional diagram of a flexible printed circuit according to some embodiments of this application;
FIG. 29 is a diagram 2 of a flexible printed circuit according to some other embodiments of this application;
FIG. 30 is a cross-sectional diagram of a printed circuit board according to some other embodiments of this application; and
FIG. 31 is a comparison diagram of isolation effect between this application and the conventional technology.

### Reference numerals:

1: mechanical part; 11: cavity; 12: third isolation rib; 121: third upper isolation rib; 122: third lower isolation rib; 13: second opening; 14: conductive adhesive; 15: first protrusion; 16: second protrusion; 17: third opening;
2: printed circuit board; 21: first isolation strip; 211: dividing groove; 22: second isolation strip;
3: conductive contact component; 31: signal transmission conductive contact; 32: signal receiving conductive contact;
4: optical device; 41: pin;
5: flexible printed circuit; 51: second conductive area; 52: extension plate; 53: through via;
6: signal transmission line;
7: signal receiving line;
8: ground line;
9: socket; 91: slot; 92: first isolation rib; 93: second isolation rib; 931: second upper isolation rib; 932: second lower isolation rib; 94: first opening;
10: barrier member;
20: wave-absorbing material;
100: optoelectronic device;
200: optical fiber.

### DESCRIPTION OF EMBODIMENTS

To make the objectives, technical solutions, and advantages of this application clearer, the following further describes the implementations of this application in detail with reference to the accompanying drawings.

An embodiment of this application provides an optical communication component, including an optoelectronic device and a socket. In the field of optical communication, the optoelectronic device (also referred to as an optical module) is a tool for implementing mutual conversion between an optical signal and an electrical signal, and is one of key components in an optical communication device. The optoelectronic device can be inserted into a socket of a communication device, and is electrically connected to the communication device, to implement signal transmission and reception of the communication device.

In this application, the optical communication component may be used in a wireless transmission scenario, for example, a router, a switch, or a wireless station. This is not limited in this application. The following describes an example in which the optical communication component is used in a wireless small cell system.

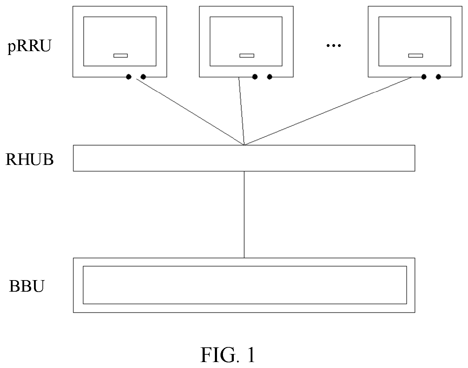

FIG. 1 is a diagram of a structure of a wireless small cell system. Refer to FIG. 1. The wireless small cell system includes a pRRU (Pico Remote Radio Unit, pico remote radio module), an RHUB (Radio HUB, radio hub unit), and a BBU (baseband unit, baseband unit). The pRRU is configured to process a radio frequency signal. The pRRU can modulate a baseband signal to a transmit frequency band, and after filtering and amplification, transmit the baseband signal through an antenna. The pRRU can further receive a radio frequency signal from an antenna, and after filtering and amplification, down-convert the radio frequency signal, and sends the radio frequency signal to the RHUB for processing. The RHUB is used together with the pRRU and BBU to provide indoor coverage, receive downlink data sent by the BBU and forward the downlink data to pRRUs, and forward uplink data of a plurality of pRRUs to the BBU. The BBU is configured to provide an external interface for connecting to a transmission device, a radio frequency module, a USB^{a} device, an external clock source, and LMT or MAE, to implement functions such as signal transmission, automatic base station software upgrade, clock reception, and BBU maintenance on the LMT or MAE. The BBU also can centrally manage the entire base station system and perform functions such as uplink and downlink data processing, signaling processing, resource management, and operation and maintenance.

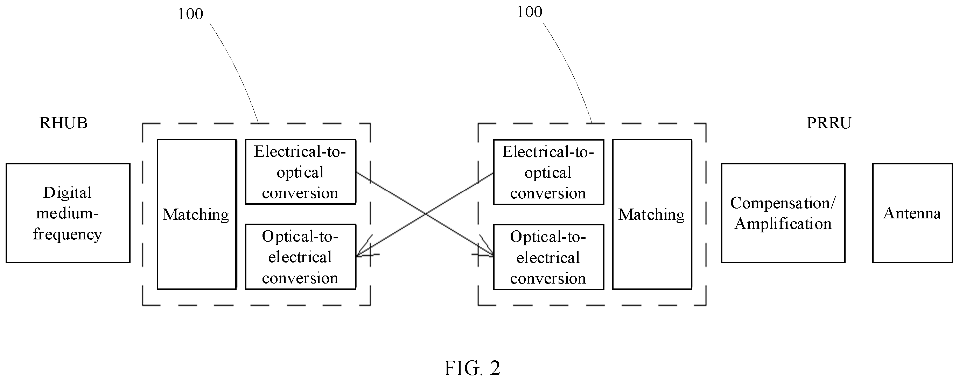

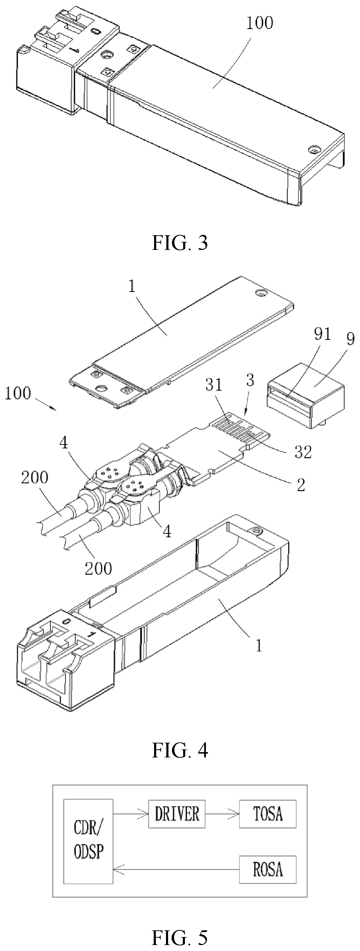

FIG. 2 is a block diagram of a structure of a wireless small cell system. Refer to FIG. 2. A socket is disposed on each of a pRRU and an RHUB, and an optoelectronic device 100 (as shown in FIG. 3) can be inserted into the socket, so that the optoelectronic device 100 is electrically connected to the pRRU or the RHUB. An optoelectronic device 100 inserted into the pRRU socket and an optoelectronic device 100 inserted into the RHUB socket can transmit a signal via an optical fiber.

Further, with reference to FIG. 4, the optoelectronic device 100 includes a mechanical part 1 and a printed circuit board 2 (PCB board) disposed in the mechanical part. A conductive contact component 3, an optical device 4, and a functional circuit (not shown) are disposed on the printed circuit board 2, and the conductive contact component 3 is electrically connected to the optical device 4 by using the functional circuit. For example, the conductive contact component 3 may be a gold finger component. During use of the optoelectronic device 100, an optical fiber 200 is inserted into the optical device 4, the conductive contact component 3 is inserted into a slot 91 of a socket 9 of the pRRU or the RHUB, and the conductive contact component 3 can be in contact with a terminal in the socket 9 to implement electrical connection. Specifically, the conductive contact component 3 includes a signal transmission conductive contact 31 and a signal receiving conductive contact 32. The signal transmission conductive contact 31 may be a signal transmission gold finger, and the signal receiving conductive contact 32 may be a signal receiving gold finger. The signal transmission conductive contact 31 and the signal receiving conductive contact 32 each are electrically connected to the optical device 4 by using the functional circuit.

Refer to FIG. 2 and FIG. 4. When an optical communication device (pRRU or RHUB) into which the optoelectronic device 100 is inserted sends a signal to the outside, an electrical signal sent by the optical communication device is transmitted to the optical device 4 sequentially through the socket 9, the signal transmission conductive contact 31, and the functional circuit. Then, the optical device 4 converts the electrical signal sent by the optical communication device into an optical signal, and transmits the optical signal obtained through conversion to the outside via the optical fiber 200. When the optical communication device into which the optoelectronic device 100 is inserted receives a signal, an optical signal is transmitted to the optical device 4 via the optical fiber 200, the optical device 4 converts the optical signal into an electrical signal, and then the electrical signal is transmitted to the optical communication device sequentially through the functional circuit, the signal receiving conductive contact 32, and the socket 9.

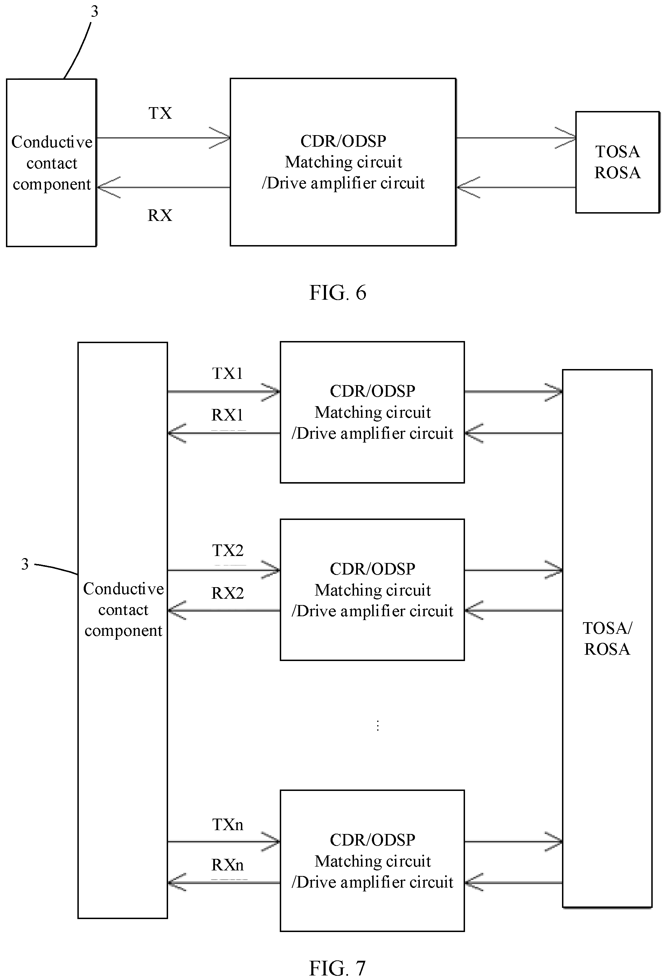

In actual application, regardless of a conventional optoelectronic device, for example, a digital optical module SFP+ (as shown in FIG. 5) or a QSFP, or an analog optoelectronic device, for example, an ROF optical module, if the signal transmission conductive contact 31 is not effectively isolated from the signal receiving conductive contact 32, signal crosstalk is generated between the signal transmission conductive contact 31 and the signal receiving conductive contact 32, affecting overall performance of the optoelectronic device. In addition, as transmission data continuously increases, an optoelectronic device has evolved from an early single-channel optoelectronic device (as shown in FIG. 6) to a multi-channel optoelectronic device (as shown in FIG. 7), and crosstalk between different channels has greater impact on the optoelectronic device.

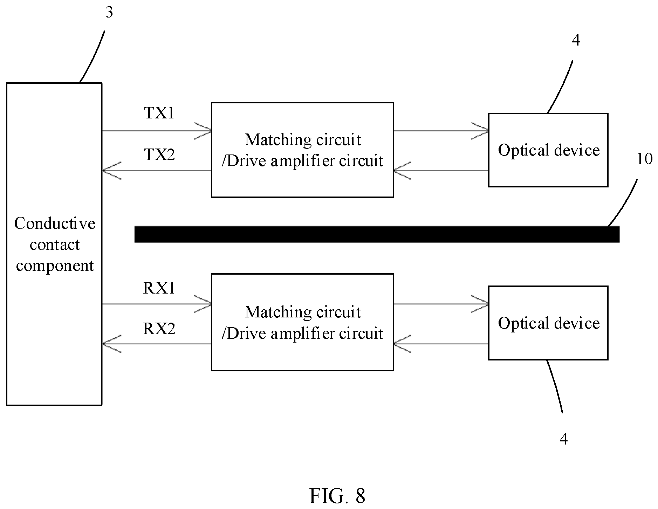

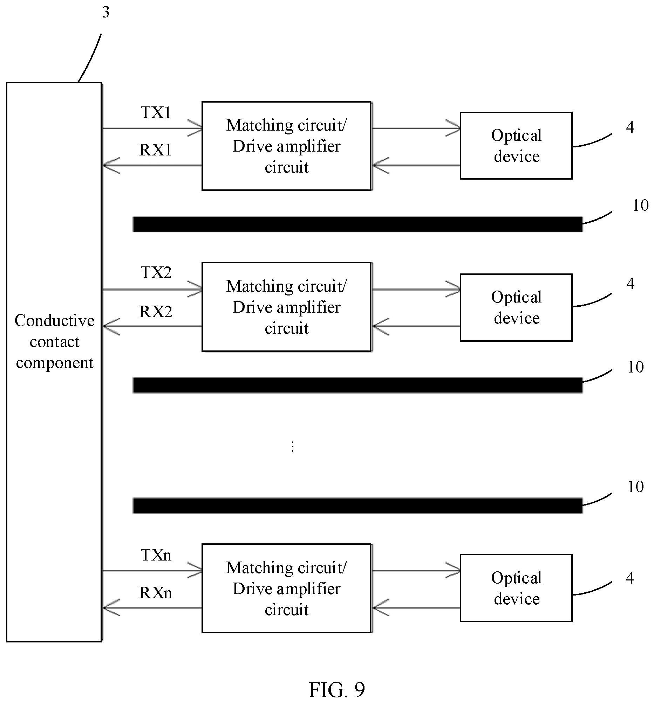

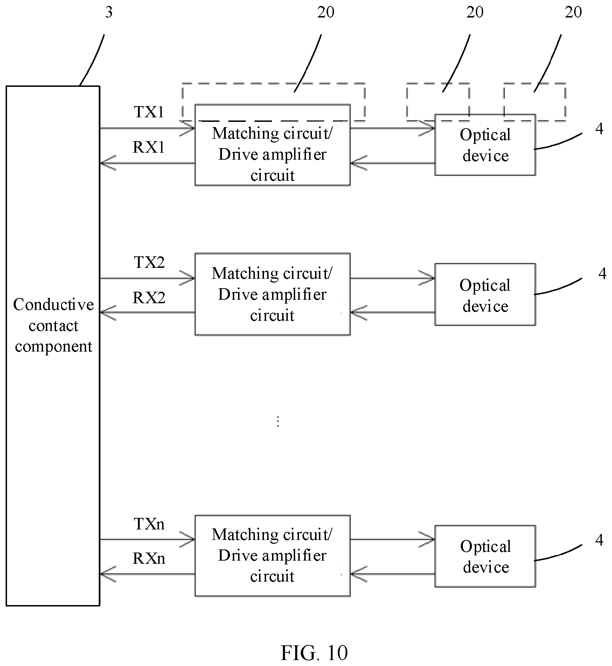

To resolve the foregoing technical problem, in some implementations, with reference to FIG. 8 and FIG. 9, a barrier member 10 is disposed on the printed circuit board, the barrier member 10 extends along an extension direction of a signal channel, and signal channels are separated by the barrier member 10 in different areas. In this technical solution, crosstalk between the signal channels can be mitigated to some extent. However, due to a structure limitation, isolation can only be achieved in a partial area, and the signal transmission conductive contact 31 and the signal receiving conductive contact 32 that are inserted into the socket 9 in FIG. 4 cannot be isolated. As a result, the isolation is low, and performance of the optoelectronic device is still affected. In some other implementations, with reference to FIG. 10, signal radiation may be further reduced by covering some circuits with a wave-absorbing material 20, to mitigate crosstalk. However, the wave-absorbing material 20 affects signal transmission performance, and brings some adverse impact.

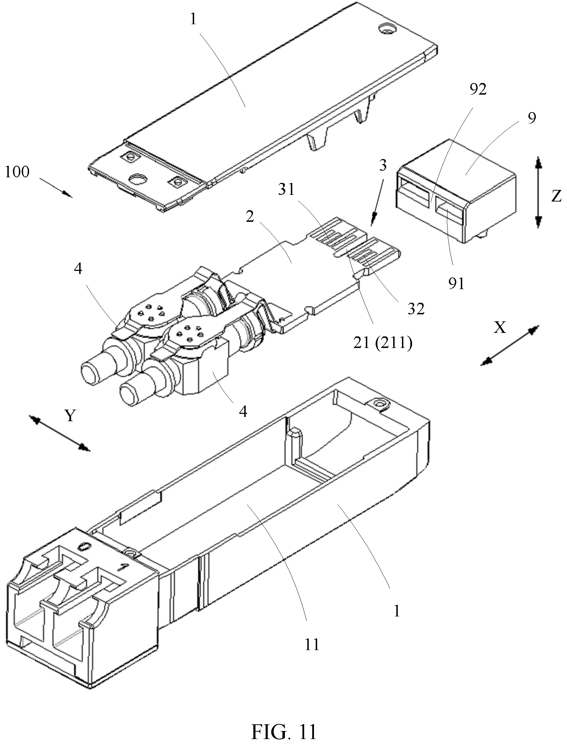

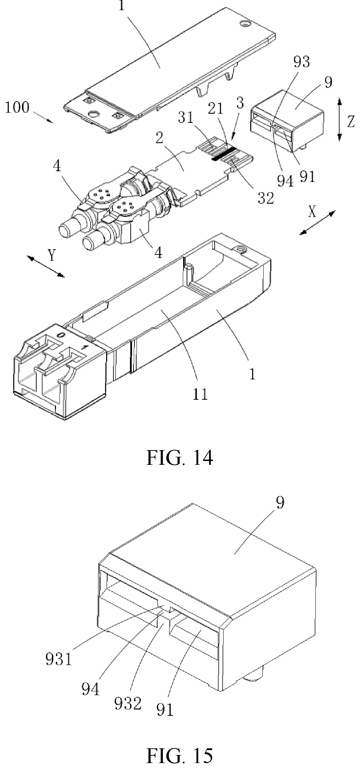

Refer to FIG. 11 and FIG. 14. This application provides an optical communication component, and the optical communication component includes an optoelectronic device 100 and a socket 9. One end of the optoelectronic device 100 can input/output an optical signal, and correspondingly, the other end of the optoelectronic device 100 outputs/inputs an electrical signal corresponding to the optical signal.

Further, the optoelectronic device 100 includes a printed circuit board 2, and two ends of the printed circuit board 2 along a length direction (an X direction shown in FIG. 11 and FIG. 14) of the printed circuit board 2 are a first end and a second end. A conductive contact component 3 is disposed at the first end of the printed circuit board 2, and the conductive contact component 3 is configured to electrically connect to a terminal in a socket 9 that is used as an insertion destination of the optoelectronic device 100. The conductive contact component 3 includes a signal transmission conductive contact 31 and a signal receiving conductive contact 32. A first isolation strip 21 extending along the length direction of the printed circuit board 2 is further disposed on the printed circuit board 2. The signal transmission conductive contact 31 and the signal receiving conductive contact 32 are located on two sides of the first isolation strip 21 along a width direction (a Y direction shown in FIG. 11 and FIG. 14) of the printed circuit board 2.

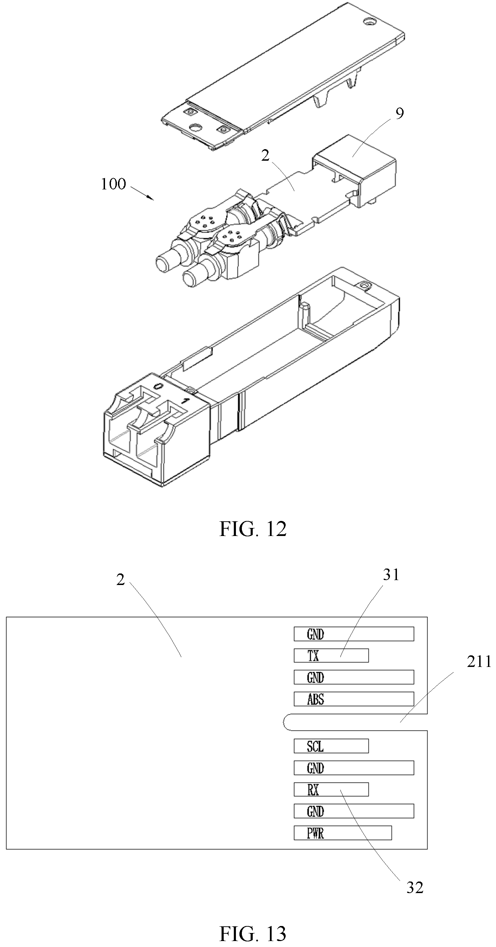

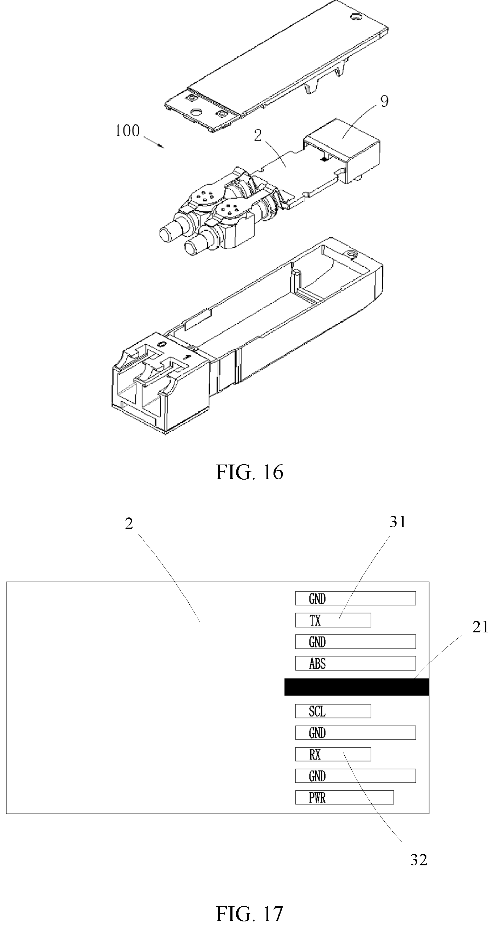

The socket 9 is provided with a slot 91, and the slot 91 can allow insertion of the conductive contact component 3. An isolation rib is disposed in the slot 91, and the isolation rib may be a first isolation rib 92 shown in FIG. 11 or a pair of second isolation ribs 93 shown in FIG. 14. When the conductive contact component 3 is inserted into the slot 91 (as shown in FIG. 12 and FIG. 16), the isolation rib can engage with the first isolation strip 21, to form a first isolation portion that isolates the signal transmission conductive contact 31 from the signal receiving conductive contact 32.

In this application, a first isolation strip 21 is disposed on the printed circuit board 2, and the isolation rib is disposed in the socket 9. In this case, after the conductive contact component 3 is inserted into the socket 9, the first isolation strip 21 on the printed circuit board 2 can be in lap joint with the isolation rib in the socket 9 to form the first isolation portion, and the first isolation portion can separate the signal transmission conductive contact 31 and the signal receiving conductive contact 32 in different isolation cavities, to implement physical isolation between the signal transmission conductive contact 31 and the signal receiving conductive contact 32, thereby mitigating crosstalk between a transmitted signal and a received signal.

In addition, in this application, the first isolation strip 21 on the printed circuit board 2 is in lap joint with the isolation rib in the socket 9 to form the first isolation portion, so that the signal transmission conductive contact 31 and the signal receiving conductive contact 32 that are inserted into the socket 9 can be isolated from each other, thereby enhancing isolation, and avoiding a problem of low isolation in the technical solutions shown in FIG. 8 and FIG. 9 and a problem of affecting signal transmission performance in the technical solution shown in FIG. 10.

A specific mechanism of the first isolation strip 21 is not limited in this application. Any structure that can engage with the isolation rib in the socket 9 to isolate the signal transmission conductive contact 31 from the signal receiving conductive contact 32 falls within the protection scope of this application.

In some implementations of this application with reference to FIG. 11 to FIG. 13, the first isolation strip 21 is a dividing groove 211. The first isolation rib 92 extending along a thickness direction of the slot 91 (a Z direction shown in FIG. 11) is disposed in the slot 91 of the socket 9, two ends of the first isolation rib 92 are respectively connected to a top surface and a bottom surface of the slot 91 in the Z direction, and a width of the dividing groove 211 matches a width of the first isolation rib 92.

When the conductive contact component 3 is inserted into the socket 9, as shown in FIG. 12, the first isolation rib 92 is inserted into the dividing groove 211 to form the first isolation portion, so as to separate the signal transmission conductive contact 31 and the signal receiving conductive contact 32 in different isolation space.

In some implementations of this application, a conductive layer grounded is disposed on a side wall of the dividing groove 211, the first isolation rib 92 is made of a conductive material and is grounded, and when the first isolation rib 92 is inserted into the dividing groove 211, the first isolation rib 92 is in contact with the conductive layer. For example, both the first isolation rib 92 and the conductive layer are made of a metal material, and the conductive layer covers the entire side wall of the dividing groove 211.

In some other implementations of this application with reference to FIG. 14 to FIG. 19, as shown in FIG. 14 and FIG. 17, the first isolation strip 21 is located on the printed circuit board 2, is made of a conductive material, and is grounded. In addition, the pair of second isolation ribs 93 corresponding to a position of the first isolation strip 21 are disposed in the slot 91 of the socket 9.

Specifically, as shown in a schematic detailed diagram of the socket shown in FIG. 15, the pair of second isolation ribs 93 include a second upper isolation rib 931 and a second lower isolation rib 932. Both the second upper isolation rib 931 and the second lower isolation rib 932 are made of a conductive material and are grounded. The second upper isolation rib 931 is connected to the top surface of the slot 91, the second lower isolation rib 932 is connected to the bottom surface of the slot 91, and a first opening 94 corresponding to a thickness of the first isolation strip 21 is provided between the second upper isolation rib 931 and the second lower isolation rib 932.

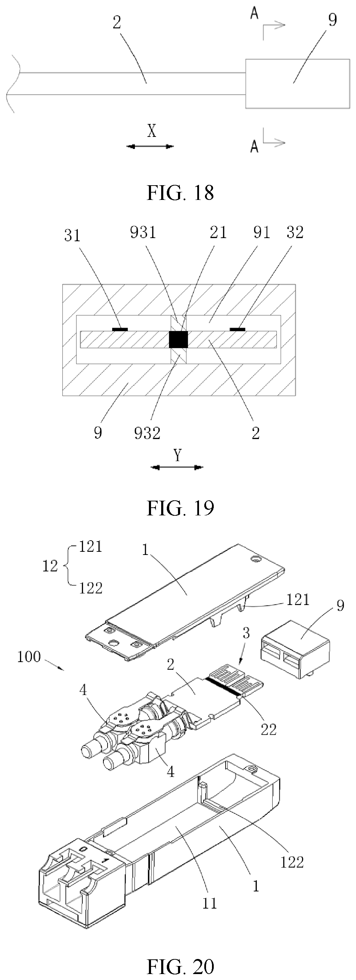

When the conductive contact component 3 is inserted into the socket 9, as shown in FIG. 16, FIG. 18, and FIG. 19, the first isolation strip 21 is inserted into the first opening 94, and the pair of second isolation ribs 93 are respectively in lap joint with the first isolation strip 21 from upper and lower sides of a plane on which the printed circuit board 2 is located. To be specific, as shown in FIG. 19, the second upper isolation rib 931 is in contact with an upper surface of the first isolation strip 21, and the second lower isolation rib 932 is in contact with a lower surface of the first isolation strip 21, to form the first isolation portion. The first isolation portion can separate the signal transmission conductive contact 31 and the signal receiving conductive contact 32 in different isolation space.

In this application, both the first isolation strip 21 and the isolation rib in the socket 9 are grounded, so that signal isolation effect between the signal transmission conductive contact 31 and the signal receiving conductive contact 32 can be enhanced.

Refer to FIG. 11 and FIG. 14. In some implementations of this application, the optoelectronic device 100 further includes the mechanical part 1 and the optical device 4. A cavity 11 is provided in the mechanical part 1, the printed circuit board 2 is disposed in the cavity 11, and the optical device 4 is disposed at the second end of the printed circuit board 2.

In some implementations of this application, with reference to FIG. 20 to FIG. 22, a second isolation strip 22 extending along the width direction of the printed circuit board 2 is further disposed on the printed circuit board 2. The conductive contact component 3 and the optical device 4 are located on two sides of the second isolation strip 22 along the length direction of the printed circuit board 2, an isolation rib is disposed in the mechanical part 1, and the second isolation strip 22 is configured to engage with the isolation rib in the mechanical part 1, to form a second isolation portion of the conductive contact component 3.

In this application, the second isolation strip 22 is disposed on the printed circuit board 2, so that the second isolation strip 22 is in lap joint with the isolation rib in the mechanical part 1 to form the second isolation portion. The second isolation portion can separate the conductive contact component 3 and another element (for example, the optical device 4) on the printed circuit board 2 in different isolation cavities, to implement physical isolation between the conductive contact component 3 and the another element, thereby mitigating crosstalk between the conductive contact component 3 and the another element, and improving performance of the optoelectronic device.

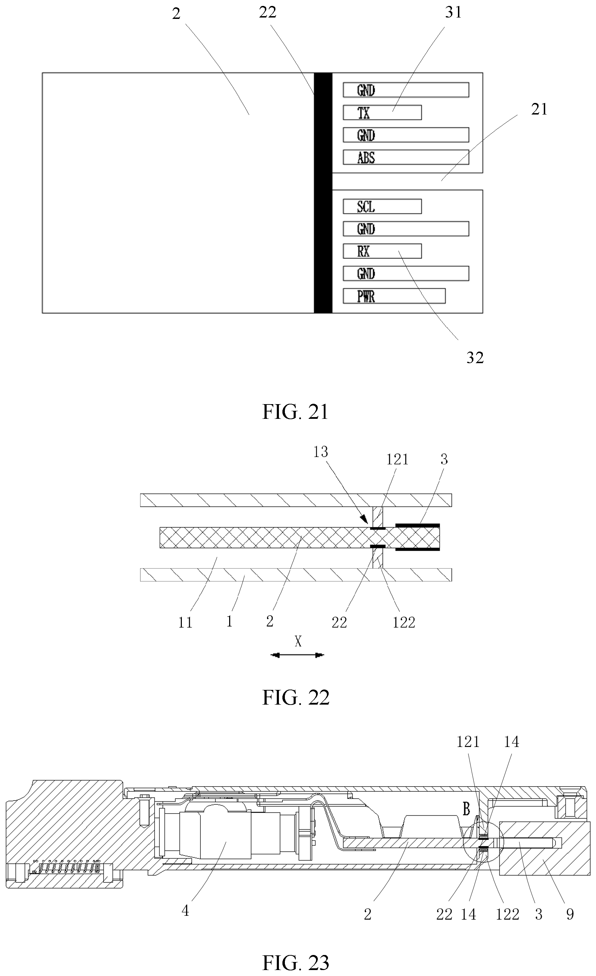

In some implementations of this application, with reference to FIG. 21, the second isolation strip 22 is located on the printed circuit board 2, is made of a conductive material, and is grounded. Refer to FIG. 20. A pair of third isolation ribs 12 corresponding to a position of the second isolation strip 22 are disposed in the cavity 11 of the mechanical part 1. Specifically, as shown in FIG. 22, the pair of third isolation ribs 12 include a third upper isolation rib 121 and a third lower isolation rib 122, and both the third upper isolation rib 121 and the third lower isolation rib 122 are made of a conductive material and are grounded. The third upper isolation rib 121 is connected to a top surface of the cavity 11, the third lower isolation rib 122 is connected to a bottom surface of the cavity 11, and a second opening 13 corresponding to a thickness of the second isolation strip 22 is provided between the third upper isolation rib 121 and the third lower isolation rib 122. The printed circuit board 2 is inserted into the second opening 13, and the pair of third isolation ribs 12 are respectively in lap joint with the second isolation strip 22 from two sides of the plane on which the printed circuit board 2 is located. To be specific, the third upper isolation rib 121 is in contact with an upper surface of the second isolation strip 22, and the third lower isolation rib 122 is in contact with a lower surface of the second isolation strip 22, to form the second isolation portion. The second isolation portion can separate the conductive contact component 3 and another element on the printed circuit board 2 in different isolation space.

In this application, both the second isolation strip 22 and the isolation ribs in the mechanical part 1 are grounded, so that signal isolation effect between the conductive contact component 3 and the optical device 4 can be enhanced.

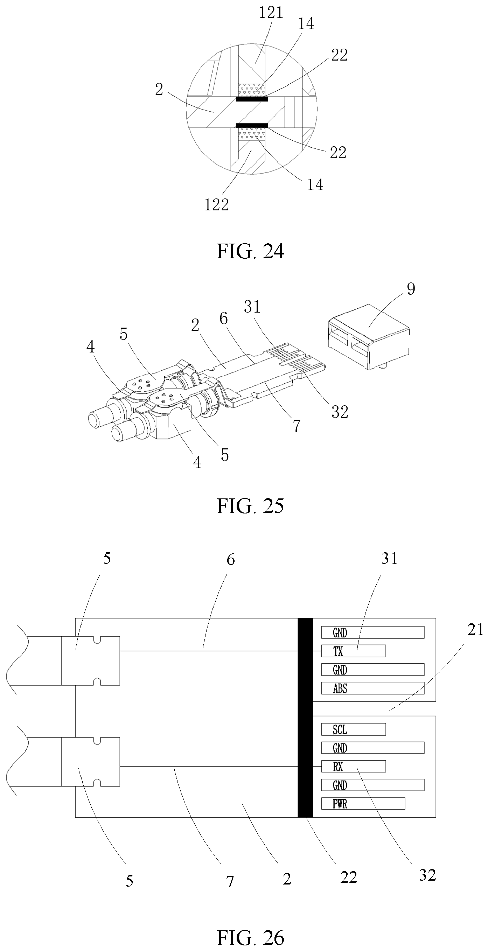

In some implementations of this application, with reference to FIG. 23 and FIG. 24, a conductive adhesive 14 is provided between the third upper isolation rib 121 and the printed circuit board 2, and between the third lower isolation rib 122 and the printed circuit board 2. In this application, the conductive adhesive 14 is provided, to enhance sealing of the isolation cavity, thereby ensuring tight isolation.

In some implementations of this application, with reference to FIG. 25 and FIG. 26, the optoelectronic device provided in this application further includes a flexible printed circuit 5 (an FPC board), a signal transmission line 6, and a signal receiving line 7. The flexible printed circuit 5 is disposed between the optical device 4 and the printed circuit board 2, and the flexible printed circuit 5 is configured to connect the optical device 4 and the printed circuit board 2. The signal transmission line 6 extends along the length direction of the printed circuit board 2. One end of the signal transmission line 6 is electrically connected to the signal transmission conductive contact 31, and the other end of the signal transmission line 6 is electrically connected to the optical device 4 sequentially through the printed circuit board 2 and the flexible printed circuit 5. The signal transmission line 6 is configured to transmit a signal sent by the signal transmission conductive contact 31 to the optical device 4. The signal receiving line 7 extends along the length direction of the printed circuit board 2. One end of the signal receiving line 7 is electrically connected to the signal receiving conductive contact 32, and the other end of the signal receiving line 7 is electrically connected to the optical device 4 sequentially through the printed circuit board 2 and the flexible printed circuit 5. The signal receiving line 7 is configured to transmit a signal sent by the optical device 4 to the signal receiving conductive contact 32.

When the socket 9 sends a signal to the outside, an electrical signal sent by the socket 9 is transmitted to the optical device 4 sequentially through the signal transmission conductive contact 31 and the signal transmission line 6, and then the optical device 4 converts the electrical signal sent by the socket 9 into an optical signal, and transmits the optical signal to the outside. When an optical signal is transmitted from the outside, the optical device 4 converts the optical signal into an electrical signal, and then the electrical signal is transmitted to the socket 9 sequentially through the signal receiving line 7 and the signal receiving conductive contact 32, so that the socket 9 receives the signal.

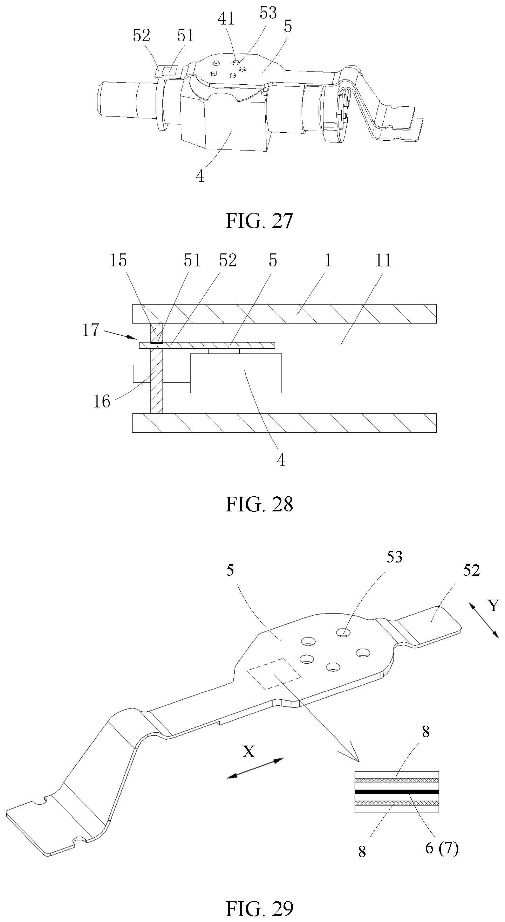

For example, with reference to FIG. 27, a through via 53 is provided in the flexible printed circuit 5, a pin 41 is disposed on the optical device 4, and the pin 41 is inserted into the through via 53, to implement connection between the optical device 4 and the flexible printed circuit 5.

In some implementations of this application, with reference to FIG. 27, a second conductive area 51 is provided on the flexible printed circuit 5, and the second conductive area 51 is grounded. Refer to FIG. 28. A first protrusion 15 corresponding to a position of the second conductive area 51 is disposed in the cavity 11 of the mechanical part 1, the first protrusion 15 is made of a conductive material and is grounded, and the first protrusion 15 is in contact with the second conductive area 51.

Through exploration, the inventor finds that impedance discontinuity occurs at a joint between the optical device 4 and the flexible printed circuit 5, and an electromagnetic wave is likely to be radiated to the outside. Moreover, due to limited internal space of the optoelectronic device, the joint between the optical device 4 and the flexible printed circuit 5 is difficult to be completely shielded, which causes a radiation signal to couple in. In this application, the second conductive area 51 grounded is provided on the flexible printed circuit 5, and the second conductive area 51 is in lap joint with the grounded first protrusion 15, so that an anti-radiation capability of the optical device 4 and the flexible printed circuit 5 can be enhanced, radiation to the outside is reduced, and isolation is improved.

In some implementations of this application, with reference to FIG. 27 and FIG. 28, an extension plate 52 is disposed on the flexible printed circuit 5, and the second conductive area 51 is provided on the extension plate 52. A second protrusion 16 disposed opposite to the first protrusion 15 is disposed in the cavity 11 of the mechanical part 1, a third opening 17 is provided between the first protrusion 15 and the second protrusion 16, and the extension plate 52 is disposed in the third opening 17. The first protrusion 15 and the second protrusion 16 are in contact with the extension plate 52 on two sides of a plane on which the extension plate 52 is located, to clamp the extension plate 52 in the third opening 17, so that the second conductive area 51 can be in close contact with the first protrusion 15, thereby enhancing reliability of an apparatus.

In some implementations of this application, the flexible printed circuit 5 has an upper surface layer, a lower surface layer, and an inner layer, the inner layer is disposed between the upper surface layer and the lower surface layer, and both the signal transmission line 6 and the signal receiving line 7 are routed in the inner layer of the flexible printed circuit 5. This design can enhance isolation between the signal transmission line 6 and the signal receiving line 7, reduce interference between the signal transmission line 6 and the signal receiving line 7, and can also prevent the signal transmission line 6 and the signal receiving line 7 from interfering with another channel or being interfered by another channel.

In some implementations of this application, with reference to FIG. 29, the signal transmission line 6 and the signal receiving line 7 are routed on a surface layer of the flexible printed circuit 5, one ground line 8 is disposed on each of two sides of the signal transmission line 6 and/or the signal receiving line 7 along the width direction (as shown in a Y direction in FIG. 29) of the printed circuit board 2, and the ground line 8 extends along an extension direction (as shown in an X direction in FIG. 29) of the signal transmission line 6 and the signal receiving line 7. Because a radiation signal generated by the signal transmission line 6 is higher than that of the signal receiving line 7, the signal transmission line 6 is likely to interfere with the signal receiving line 7. In this application, electromagnetic radiation of the signal transmission line 6 to the signal receiving line 7 can be restricted by disposing one ground line 8 on each of two sides of the signal transmission line 6. An anti-radiation capability of the signal receiving line 7 may be enhanced by disposing one ground line 8 on each of two sides of the signal receiving line 7.

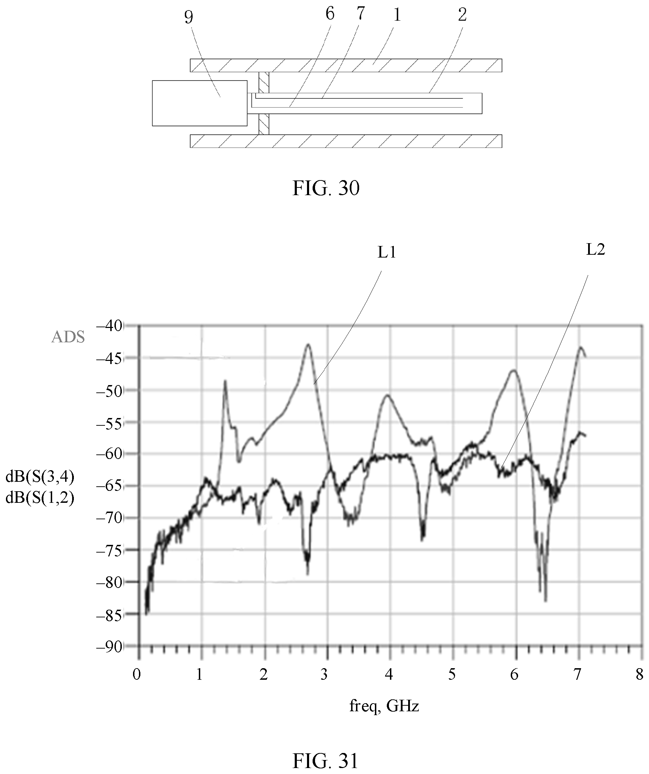

In some implementations of this application, with reference to FIG. 30, the printed circuit board 2 has an upper surface layer, a lower surface layer, and a plurality of inner layers. When the signal transmission line 6 and the signal receiving line 7 are routed in the same printed circuit board 2, the signal transmission line 6 and the signal receiving line 7 are routed in different inner layers of the same printed circuit board 2. When there are two printed circuit boards 2, the signal transmission line 6 and the signal receiving line 7 are respectively routed in inner layers of the two printed circuit boards 2. The foregoing design may enhance isolation between the signal transmission line 6 and the signal receiving line 7, thereby reducing interference between the signal transmission line 6 and the signal receiving line 7.

FIG. 31 is an experimental comparison diagram of isolation effect between this application and the conventional technology. In FIG. 31, a line L1 represents isolation between a signal receiving channel and a signal transmission channel in conventional technology, and a line L2 represents isolation between a signal receiving channel and a signal transmission channel after implementation of this application. It is proved through experiments that, when this application is not implemented, the isolation between the signal receiving channel and the signal transmission channel is poor, and can only reach appropriately -40 dB. After this application is implemented, the isolation between the signal receiving channel and the signal transmission channel is significantly improved, and can reach more than -55 dB.

This application further provides a socket. Refer to FIG. 11 and FIG. 14. The socket 9 is provided with the slot 91, and the slot 91 can allow insertion of any optoelectronic device described with reference to FIG. 11 to FIG. 30 in the foregoing embodiments. An isolation rib is disposed in the slot 91, and the isolation rib may be the first isolation rib 92 shown in FIG. 11 or the pair of second isolation ribs 93 shown in FIG. 14. When the optoelectronic device 100 is inserted into the slot 91, the isolation rib in the slot 91 can engage with the first isolation strip 21 on the optoelectronic device 100, to form the first isolation portion that isolates the signal transmission conductive contact 31 from the signal receiving conductive contact 32.

This application further provides an optical communication device, including any optical communication component described with reference to FIG. 11 to FIG. 30 in the foregoing embodiments.

The foregoing describes implementations of this application in specific embodiments, and other advantages and effects of this application may be readily understood by a person skilled in the art from content disclosed in this specification. Although this application is described with reference to some embodiments, it does not mean that a characteristic of this application is limited only to this implementation. On the contrary, a purpose of describing this application with reference to an implementation is to cover another option or modification that may be derived based on claims of this application. This application may alternatively be implemented without using these details. In addition, to avoid confusion or blurring a focus of this application, some details are omitted from the descriptions. It should be noted that embodiments in this application and the features in embodiments may be mutually combined in the case of no conflict.

In embodiments of this application, the terms "first", "second", and "third" are merely intended for a purpose of description, and shall not be understood as an indication or implication of relative importance or an implication of a quantity of indicated technical features. Therefore, the features defined with "first", "second", and "third" may explicitly or implicitly include one or more of the features.

The term "and/or" in embodiments of this application describes only an association relationship for describing associated objects and represents that three relationships may exist. For example, A and/or B may represent the following three cases: Only A exists, both A and B exist, and only B exists. In addition, the character "/" in this specification generally indicates an "or" relationship between the associated objects.

In the descriptions of embodiments of this application, it should be noted that the terms "mounting" and "connection" should be understood in a broad sense unless there is a clear stipulation and limitation. For example, "connection" may be detachable connection, nondetachable connection, direct connection, or indirect connection through an intermediate medium.

In the descriptions of this application, it should be noted that orientation or position relationships indicated by terms "upper", "lower", "top", "bottom", and the like are orientation or position relationships based on the accompanying drawings, and are only intended to facilitate and simplify the description of this application, but are not intended to indicate or imply that an apparatus or an element needs to have a specific orientation and be constructed and operated in a specific orientation, and therefore cannot be understood as a limitation on this application.

In the descriptions of this application, it should be noted that unless otherwise explicitly specified and limited, terms such as "dispose", "mount", "connect", and "attach" should be understood in a broad sense. For example, such terms may indicate a fixed connection, a detachable connection, or an integral connection, may indicate a mechanical connection or an electrical connection, and may indicate a direct connection, an indirect connection through an intermediate medium, or an internal communication between two elements. A person of ordinary skill in the art may understand a specific meaning of the foregoing term in this application based on a specific situation.

It is clearly that a person skilled in the art can make various modifications and variations to this application without departing from the spirit and scope of this application. This application is intended to cover these modifications and variations of this application provided that they fall within the scope of protection defined by the following claims and their equivalent technologies.

## Claims

1. An optical communication component, comprising an optoelectronic device and a socket, wherein
the optoelectronic device comprises a printed circuit board, two ends of the printed circuit board along a length direction of the printed circuit board are a first end and a second end, a conductive contact component is disposed at the first end of the printed circuit board, the conductive contact component comprises a signal transmission conductive contact and a signal receiving conductive contact, a first isolation strip extending along the length direction of the printed circuit board is further disposed on the printed circuit board, and the signal transmission conductive contact and the signal receiving conductive contact are located on two sides of the first isolation strip along a width direction of the printed circuit board; and
the socket is provided with a slot, the slot can allow insertion of the conductive contact component, an isolation rib is disposed in the slot, and when the conductive contact component is inserted into the slot, the isolation rib can engage with the first isolation strip, to form the first isolation portion that isolates the signal transmission conductive contact from the signal receiving conductive contact.

2. The optical communication component according to claim 1, wherein the first isolation strip is a dividing groove, a first isolation rib is disposed in the socket, and a width of the dividing groove matches the first isolation rib; and
when the conductive contact component is inserted into the socket, the first isolation rib is inserted into the dividing groove to form the first isolation portion, to separate the signal transmission conductive contact and the signal receiving conductive contact in different isolation space.

3. The optical communication component according to claim 2, wherein a conductive layer grounded is disposed on a side wall of the dividing groove, the first isolation rib is made of a conductive material and is grounded, and when the first isolation rib is inserted into the dividing groove, the first isolation rib is in contact with the conductive layer.

4. The optical communication component according to claim 1, wherein
the first isolation strip is located on the printed circuit board, is made of a conductive material, and is connected to a ground;
a pair of second isolation ribs corresponding to a position of the first isolation strip are disposed in the socket, the pair of second isolation ribs are made of a conductive material and are grounded, and a first opening corresponding to a thickness of the first isolation strip is provided between the pair of second isolation ribs; and
when the conductive contact component is inserted into the socket, the first isolation strip is inserted into the first opening, and the pair of second isolation ribs are respectively in lap joint with the first isolation strip from two sides of a plane on which the printed circuit board is located, to form the first isolation portion, and the first isolation portion can separate the signal transmission conductive contact and the signal receiving conductive contact in different isolation space.

5. The optical communication component according to claim 1, wherein the optoelectronic device further comprises:
a mechanical part, wherein a cavity is provided in the mechanical part, and the printed circuit board is disposed in the cavity; and
an optical device, disposed at the second end of the printed circuit board.

6. The optical communication component according to claim 5, wherein a second isolation strip extending along the width direction of the printed circuit board is disposed on the printed circuit board, the conductive contact component and the optical device are located on two sides of the second isolation strip along the length direction of the printed circuit board, an isolation rib is disposed in the mechanical part, and the second isolation strip is configured to engage with the isolation rib in the mechanical part, to form a second isolation portion that isolates the conductive contact component from the optical device.

7. The optical communication component according to claim 6, wherein
the second isolation strip is located on the printed circuit board, is made of a conductive material, and is connected to a ground;
a pair of third isolation ribs corresponding to a position of the second isolation strip are disposed in the cavity of the mechanical part, the pair of third isolation ribs are made of a conductive material and are grounded, and a second opening corresponding to a thickness of the second isolation strip is provided between the pair of third isolation ribs; and
the printed circuit board is inserted into the second opening, and the pair of third isolation ribs are respectively in lap joint with the second isolation strip from two sides of a plane on which the printed circuit board is located, to form the second isolation portion isolating the conductive contact component.

8. The optical communication component according to claim 7, wherein a conductive adhesive is provided between the pair of third isolation ribs and the two sides of the plane on which the printed circuit board is located.

9. The optical communication component according to claim 5, further comprising:
a flexible printed circuit, disposed between the optical device and the printed circuit board, wherein the flexible printed circuit is configured to connect the optical device and the printed circuit board;
a signal transmission line, extending along the length direction of the printed circuit board, wherein one end of the signal transmission line is electrically connected to the signal transmission conductive contact, the other end of the signal transmission line is electrically connected to the optical device sequentially through the printed circuit board and the flexible printed circuit, and the signal transmission line is configured to transmit a signal sent by the signal transmission conductive contact to the optical device; and
a signal receiving line, extending along the length direction of the printed circuit board, wherein one end of the signal receiving line is electrically connected to the signal receiving conductive contact, the other end of the signal receiving line is electrically connected to the optical device sequentially through the printed circuit board and the flexible printed circuit, and the signal receiving line is configured to transmit a signal sent by the optical device to the signal receiving conductive contact.

10. The optical communication component according to claim 9, wherein a second conductive area is provided on the flexible printed circuit, the second conductive area is connected to a ground, a first protrusion corresponding to a position of the second conductive area is disposed in the cavity of the mechanical part, the first protrusion is made of a conductive material and is grounded, and the first protrusion is in contact with the second conductive area.

11. The optical communication component according to claim 10, wherein an extension plate is disposed on the flexible printed circuit, the second conductive area is provided on the extension plate, a second protrusion disposed opposite to the first protrusion is disposed in the cavity of the mechanical part, a third opening is provided between the first protrusion and the second protrusion, the extension plate is disposed in the third opening, and the first protrusion and the second protrusion are in contact with the extension plate from two sides of a plane on which the extension plate is located.

12. The optical communication component according to claim 9, wherein both the signal transmission line and the signal receiving line are routed in an inner layer of the flexible printed circuit.

13. The optical communication component according to claim 9, wherein the signal transmission line and the signal receiving line are routed on a surface layer of the flexible printed circuit, one ground line is disposed on each of two sides of the signal transmission line and/or the signal receiving line along the width direction of the printed circuit board, and the ground line extends along the length direction of the printed circuit board.

14. The optical communication component according to claim 9, wherein the printed circuit board comprises a plurality of inner layers, and the signal transmission line and the signal receiving line are routed in different inner layers of the same printed circuit board.

15. The optical communication component according to claim 9, wherein there are two printed circuit boards, and the signal transmission line and the signal receiving line are respectively routed in inner layers of the two printed circuit boards.

16. A socket, wherein the socket is provided with a slot, an isolation rib is disposed in the slot, the slot can allow insertion of the optoelectronic device in the optical communication component according to any one of claims 1 to 15, and when the optoelectronic device is inserted into the slot, the isolation rib can engage with the first isolation strip on the optoelectronic device, to form the first isolation portion that isolates the signal transmission conductive contact from the signal receiving conductive contact.

17. An optical communication device, comprising the optical communication component according to any one of claims 1 to 15.
